# FASCICULE DE BREVET EUROPEEN

(11) **EP 0 550 726 B1**
(45) Date de publication et mention de la délivrance du brevet: **27.05.1998**
(21) Numéro de dépôt: 92915950.7
(22) Date de dépôt: 10.07.1992
(51) Int. Cl.: H01L 21/285, H01L 27/148, H04N 3/15, H04N 5/217

(54) **PROCEDE DE FABRICATION D'UN CIRCUIT INTEGRE A TRANSFERT DE CHARGES AVEC SYSTEME D'ANTI-EBLOUISSEMENT**
VERFAHREN ZUR HERSTELLUNG EINER LADUNGSÜBERTRAGUNGSANORDNUNG MIT EINEM ÜBERLAUFSYSTEM
METHOD FOR PRODUCING A CHARGE-TRANSFER INTEGRATED CIRCUIT HAVING AN ANTIGLARE SYSTEM

(30) Priorité: 16.07.1991 FR 9108954
(43) Date de publication de la demande: 14.07.1993
(73) Titulaire: THOMSON-CSF SEMICONDUCTEURS SPECIFIQUES, 75008 Paris (FR)
(72) Inventeur: BLANCHARD, Pierre, F-92045 Paris-La Défense Cédex 67 (FR)
(74) Mandataire: Guérin, Michel
(86) Numéro de dépôt international: FR9200674
(87) Numéro de publication internationale: WO9302470

(56) Documents cités:
- EP-A- 0 435 257
- FR-A- 2 535 527
- FR-A- 2 637 418
- GB-A- 2 177 542
- US-A- 4 873 200
- L'ONDE ELECTRIQUE, vol. 70, no. 3, mai/juin 1990, pages 51-54, Paris, FR, D. HERAULT et al.: "Photocapteur matriciel à transfert de charges pour caméras de studio TVHD", voir page 53, figures 3,5,6
- PROCEEDINGS OF THE IEEE 1988 CUSTOM INTEGRATED CIRCUITS CONFERENCE, 16 mai 1988, pages 2241-2244, Rochester, NY, US, Y. OKITA et al.: "A novel base- emitter self-alignment process for high speed bipolar LSIS", voir page 2241, colonne D - page 2242, figure 1
- ELECTRONIC ENGINEERING, vol. 58, no. 714, juin 1986, pages 9,10,14, London, GB, "New CCD camera variants from EEV", voir page 9, figures 1,2

## Description

L'invention concerne les circuits intégrés, et plus particulièrement les dispositifs à transferts de charge.

Dans ces circuits, on a besoin de réaliser des systèmes d'antiéblouissement, pour évacuer des excès de charges qui apparaissent dans certaines zones de stockage de charge. Ces systèmes d'anti-éblouissement comportent en général des bandes conductrices très étroites, isolées d'un substrat semiconducteur dans lequel s'effectuent les transferts de charge; ces bandes allongées très étroites s'étendent en longueur de part et d'autre d'une zone dopée allongée formée dans le substrat; cette zone dopée sert de drain d'évacuation des charges en excès; les électrodes conductrices servent à créer une barrière de potentiel définissant le niveau d'excès à partir duquel les charges doivent être évacuées pour éviter l'éblouissement.

Dans la technique classique de réalisation de dispositifs d'antiéblouissement, on dépose une couche de silicium polycristallin, et on la grave pour définir les bandes semiconductrices; puis on implante une impureté de dopage dans l'intervalle entre deux bandes de silicium polycristallin pour constituer le drain en forme de bande allongée. Mais les techniques de photolithographie classiques ne permettent alors pas de réduire au dessous de 5 micromètres environ la largeur totale nécessaire pour réaliser l'ensemble des deux bandes conductrices séparées par une bande semiconductrice dopée. Or on préfèrerait réduire cette largeur à une valeur plus faible pour gagner de la place dans le circuit intégré. Ceci est particulièrement important lorsque des systèmes d'antiéblouissement doivent être prévus entre chaque colonne de pixels d'une matrice de prise d'image.

C'est pourquoi l'invention propose un nouveau procédé pour former des systèmes d'antiéblouissement dans les dispositifs à transfert de charge.

Ce procédé utilise des étapes ou groupes d'étapes connues dans d'autres techniques de réalisation de circuits intégrés. On citera notamment la demande de brevet EP-A-0 435 257.

Selon l'invention, on propose un procédé de fabrication d'un système d'antiéblouissement pour dispositif à transfert de charges, ce système comportant deux électrodes étroites isolées par rapport à un substrat semiconducteur et s'étendant symétriquement de part et d'autre d'une région dopée formée dans ce substrat et formant un drain d'évacuation de charges, comprenant les étapes suivantes :
- a) on dépose sur la surface d'un substrat une couche de masquage,
- b) on grave cette couche selon un motif définissant au moins une bande non protégée ;
- c) on forme une ouverture dans le substrat là où il n'est pas protégé par la couche de masquage, cette ouverture s'étendant également sous les bords de la couche de masquage, laissant ces bords en surplomb au-dessus de l'ouverture ;
- d) on dépose du silicium polycristallin épousant le contour du substrat et des bords en surplomb ;
- e) on enlève le silicium par gravure sans masque de sorte que des bandes de silicium très étroites subsistent essentiellement uniquement sous les bords en surplomb;
- f) on forme, postérieurement à l'étape b), une région dopée dans le substrat, formant ladite région de drain d'évacuation de charges, cette région étant autoalignée par rapport aux deux électrodes étroites.

En d'autres mots, l'essentiel du procédé selon l'invention est la formation de bandes conductrices dont la particularité est qu'elles se situent sous des bords en surplomb, c'est-à-dire que leur extension maximale en largeur est définie à partir de la longueur de surplomb des bords d'une couche de masquage qui a servi à définir une ouverture dans un substrat. Le mot substrat est pris au sens large, car la surface du substrat peut être une surface semiconductrice, ou une surface semiconductrice recouverte d'une couche isolante plus ou moins épaisse. Et l'ouverture formée dans le substrat peut être une ouverture formée dans un semiconducteur ou une ouverture formée dans une couche isolante.

D'une manière particulièrement avantageuse, on utilise pour former l'ouverture dans le substrat (étape c) une étape d'oxydation épaisse localisée (étape c1) suivie d'une étape de désoxydation (étape c2). On profite ainsi du fait que des étapes d'oxydation épaisse sont de toutes façons prévues pour d'autres éléments du circuit intégré, mais on utilise ici cette étape d'une manière non habituelle puisqu'on ne conserve pas l'oxyde épais formé. La couche de masquage est alors plus précisément une couche de masquage contre l'oxydation.

Une impureté sera implantée dans le substrat si on veut définir une région semiconductrice dopée autoalignée avec le substrat; selon les cas, cette impureté sera implantée avant l'enlèvement de l'oxyde épais, ou après gravure du silicium polycristallin.

Dans les cas où les deux grilles adjacentes à la bande semiconductrice dopée doivent rester à des potentiels identiques, il est possible de déposer une couche supplémentaire de silicium polycristallin pour combler l'intervalle entre les deux grilles au dessus de la zone semiconductrice dopée. Dans ce cas, cette deuxième couche est gravée uniformément sans masque, et l'extension latérale maximale des grilles est définie par les extrémités latérales des bandes de la première couche de silicium déposée, de manière que la gravure de la deuxième couche ne risque pas d'introduire, du fait des erreurs d'alignement possibles, une dissymétrie des électrodes par rapport à la zone de drain.

Les grilles seront isolées du substrat semiconducteur par une couche isolante mince formée avant dépôt du silicium polycristallin.

La couche de masquage peut rester ou être enlevée à la fin des étapes de fabrication indiquées ci-dessus.

La gravure du silicium polycristallin à la fin du procédé est de préférence une gravure anisotropique verticale (gravure sous plasma). Elle est effectuée de manière uniforme, c'est-à-dire sans masque, tout au moins sans masque servant à définir la largeur des lignes à réaliser.

Dans une variante de procédé particulièrement intéressante du fait de sa compatibilité avec la fabrication d'autres éléments de circuit sur le même substrat, on procède de la manière suivante :
- on part d'un substrat sur lequel on forme au moins une couche isolante épaisse (cette couche est formée en pratique par l'étape d'oxydation localisée qui est de toutes façons nécessaire pour la réalisation des autres éléments de circuit);
- on dépose une couche de masquage contre la gravure de la couche isolante épaisse;
- on grave la couche de masquage pour définir une bande non masquée;
- on grave sur toute son épaisseur la couche isolante épaisse dans la bande masquée et sous les bords de la couche de masquage pour laisser ces bords en surplomb (gravure dite avec sous-gravure) ;
- et on continue le procédé indiqué précédemment : éventuellement formation d'une couche mince isolante dans la zone mise à nu; dépôt de silicium polycristallin épousant la forme de l'ouverture et venant sous les surplombs; gravure uniforme sans masque pour enlever toute l'épaisseur du silicium polycristallin au milieu de l'ouverture dans lequel on l'a déposé, sans l'enlever au dessous des surplombs.

Le dopage du substrat pour définir une région dopée entre les bandes de silicium peut être effectué avant le dépôt du silicium polycristallin, ou après gravure de celui-ci.

Un aspect intéressant du procédé selon l'invention est son utilisation dans le cas d'une matrice de prise d'image à transfert de trame. Une telle matrice est décrite dans GB-A-2 177 542. Ces matrices comportent une zone image photosensible et une zone de mémoire de trame. La zone image comporte des colonnes de points photosensibles et la zone de mémoire comporte des colonnes de zones de stockage correspondant respectivement aux colonnes de points photosensibles. Un système d'antiéblouissement est prévu entre les colonnes adjacentes de points photosensibles, et un isolement est prévu entre les colonnes adjacentes de zones de stockage. Dans ce cas, on profite de la couche de masquage servant à définir le système antiéblouissement pour définir en même temps un isolement des colonnes de zones de stockage : on forme de l'oxyde de silicium épais selon un motif délimité à l'aide de ladite couche de masquage, ce motif définissant simultanément d'une part des colonnes d'oxyde épais séparant les colonnes adjacentes de pixels de la zone image et d'autre part des colonnes d'oxyde épais séparant les colonnes adjacentes correspondantes de zones de stockage de la zone de mémoire, et les étapes suivantes de formation du système d'antiéblouissement sont exécutées dans la zone image mais pas dans la zone de mémoire.

D'autres caractéristiques et avantages de l'invention apparaîtront à la lecture de la description détaillée qui suit et qui est faite en référence aux dessins annexés dans lesquels :
- les figures 1 à 7 représentent les étapes principales d'un premier mode de réalisation de l'invention;
- les figures 8, et 9 représentent une suite possible pour le premier mode de réalisation;
- la figure 10 représente schématiquement une matrice de prise de vue à transfert de trame;
- les figures 11 à 17 représentent les étapes d'un deuxième mode de réalisation de l'invention;
- les figures 18 à 22 représentent une autre variante de mise en oeuvre de l'invention.

Le mode de mise en oeuvre préféré selon l'invention est celui qui utilise, pour former une ouverture avec bords en surplomb, une étape d'oxydation épaisse suivie d'une désoxydation. Ce procédé sera donc décrit en détail ci-après, avec plusieurs variantes.

Dans une première variante du procédé selon l'invention, le détail des étapes de fabrication peut être le suivant :

On part d'un substrat 10 qui est par exemple un substrat semiconducteur (en pratique du silicium). Le dopage a peu d'importance; il peut s'agir d'un substrat P ou d'un substrat N, ou encore d'un substrat P ou N recouvert d'une couche épitaxiale ou d'une couche diffusée de type de conductivité opposé (N ou P).

Le substrat 10 peut aussi être recouvert d'une couche mince isolante 12, par exemple en oxyde de silicium ou nitrure de silicium ou une combinaison des deux, si on en a besoin par ailleurs dans le circuit intégré.

Enfin, le substrat peut être une simple couche semiconductrice déposée sur un autre substrat. Dans la suite, le substrat considéré sera en principe la couche semiconductrice (recouverte ou non d'isolant) dans laquelle s'effectuent les transferts de charges.

On dépose sur le substrat (10 ou 10+12) une couche 14 de masquage contre l'oxydation. Cette couche sera en principe en nitrure de silicium, avec éventuellement interposition d'oxyde de silicium au dessous du nitrure pour faciliter les opérations de gravure sélective ultérieures.

La couche 14 est photogravée par des moyens classiques pour définir une ouverture 16 dans laquelle le silicium du substrat ne sera pas protégé. L'ouverture peut avoir une largeur de 1,5 à 2 micromètres environ.

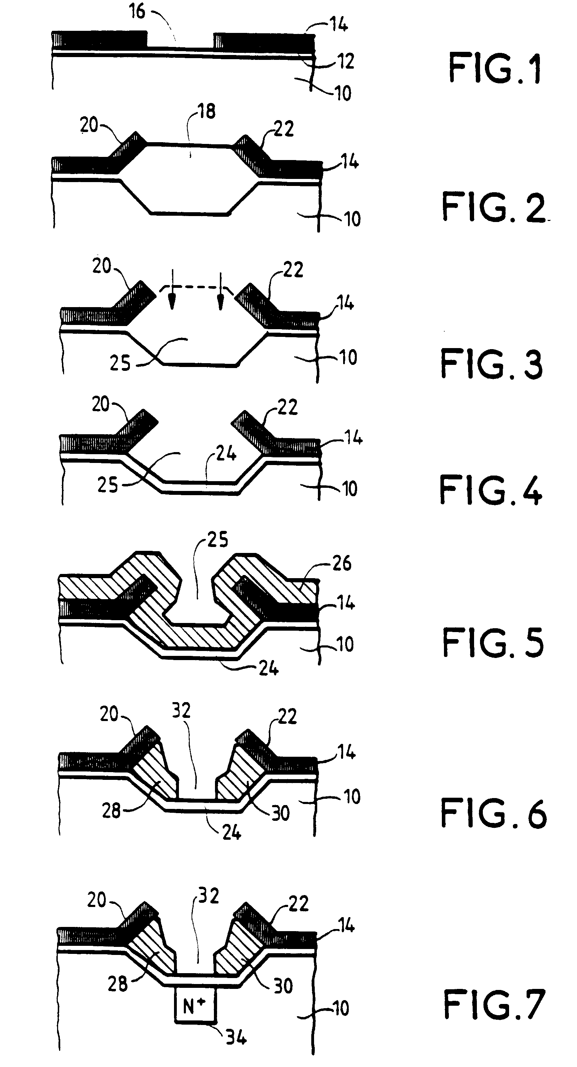

La structure obtenue est représentée à la figure 1.

On effectue alors une opération d'oxydation thermique profonde. Le silicium s'oxyde uniquement dans l'ouverture 16. De manière extrêmement classique, l'oxydation consomme du silicium en profondeur et il y a gonflement en surface ; l'oxyde 18 qui est produit soulève les bords (20,22) de la couche de nitrure de silicium 14. (figure 2).

L'oxyde épais 18 est alors enlevé par désoxydation chimique (figure 3). Les bords soulevés (20, 22) de la couche de masquage 14 restent en surplomb, ce qui est très important pour la suite du procédé. Les surplombs font saillie sur quelques dixièmes de micromètres de longueur.

Si les électrodes étroites qu'on souhaite réaliser doivent être isolées du substrat semiconducteur, ce qui sera le plus souvent le cas, on procède alors à la formation d'une couche isolante mince 24 dans le fond de l'espace évidé 25 laissé libre par la désoxydation. La couche isolante mince est de préférence formée par oxydation thermique du silicium. Elle peut avoir de quelques dizaines à quelques centaines d'angströms d'épaisseur. (figure 4).

La largeur de l'espace évidé est par exemple de l'ordre de 3 micromètres si on est parti d'une ouverture 16 de 1,5 à 2 micromètres et si l'épaisseur d'oxyde épais était de l'ordre du micromètre.

On dépose alors sur tout le substrat une couche de silicium polycristallin 26 qui épouse la forme des irrégularités de la surface et qui en particulier vient jusque sous les bords en surplomb 20, 22 du nitrure de silicium. Un dépôt par décomposition chimique en phase gazeuse permet d'obtenir ce résultat. (figure 5).

L'épaisseur de la couche de silicium déposée est choisie suffisamment faible compte tenu de la largeur de l'espace 25 pour ne pas combler l'ensemble de l'espace 25 évidé par la désoxydation. Une épaisseur de 0,5 micromètre ou inférieure convient bien.

On attaque alors, par une gravure anisotrope verticale, la couche de silicium 26, avec un produit qui n'attaque pas ou qui attaque peu le nitrure de silicium. Le silicium disparaît, sauf sous les bords en surplomb 20,22 de nitrure de silicium qui le protègent. La gravure est interrompue lorsque le nitrure est mis à nu sur l'ensemble de la surface du substrat, c'est-à-dire aussi lorsque le silicium polycristallin a été éliminé au centre de l'espace 25.

Il subsiste alors (figure 6) deux bandes conductrices très étroites 28 et 30 sous les bords en surplomb 20 et 22, ces bandes étant séparées par une bande libre 32 au milieu de l'espace 25 qui avait été évidé lors de la désoxydation.

On a ainsi réalisé deux bandes conductrices très étroites, 28,30, très rapprochées l'une de l'autre, et très symétriques, ce qui est important pour un drain antiéblouissement situé entre deux colonnes de points photosensibles; l'intervalle qui sépare les électrodes est l'intervalle très étroit 32.

L'ordre de grandeur est le suivant : largeur des bandes conductrices : environ 0,5 à 1 micromètre chacune; intervalle entre elles : environ 1 micromètre.

On procède alors à un dopage par implantation et/ou diffusion dans l'intervalle 32 entre les bandes 28 et 30; ces bandes servent de masque lors de cette opération.

C'est ce que représente la figure 7 : on a implanté par l'ouverture 32, masquée par les bandes de silicium polycristallin, une impureté du type N⁺ qui peut servir de drain d'évacuation de charges dans le cas d'un dispositif à transfert de charges photosensibles. On aboutit donc à un dispositif antiéblouissement symétrique (antiéblouissement pour des systèmes à transfert de charges situés de chaque côté du dispositif), avec deux électrodes 28, 30 encadrant une bande étroite de drain 34, la totalité de ce dispositif ayant une largeur qui peut être inférieure à 3 micromètres.

Dans une variante de réalisation, lorsque les deux électrodes doivent systématiquement rester à des potentiels identiques, on peut prévoir de modifier le procédé, notamment en le continuant par un nouveau dépôt de silicium polycristallin réunissant les deux électrodes. Cela permet de réduire la résistance d'accès des lignes. C'est ce qui est décrit en référence aux figures suivantes.

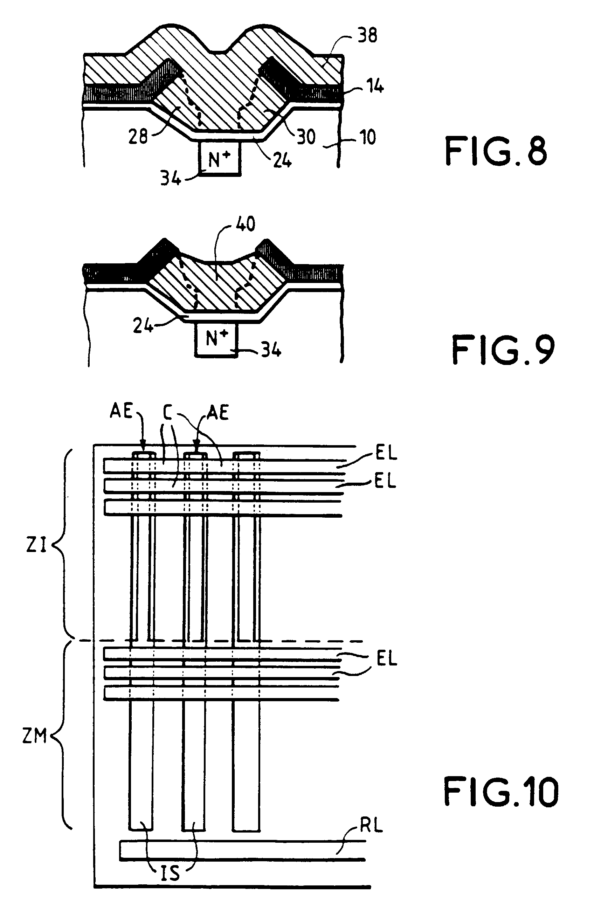

On dépose une couche de silicium 38 de préférence par décomposition chimique en phase gazeuse. L'épaisseur de dépôt est choisie suffisante pour que la couche 38 comble l'intervalle étroit 32 et produise au dessus de cet intervalle, du fait de l'étroitesse de celui-ci, une surépaisseur importante. (figure 8).

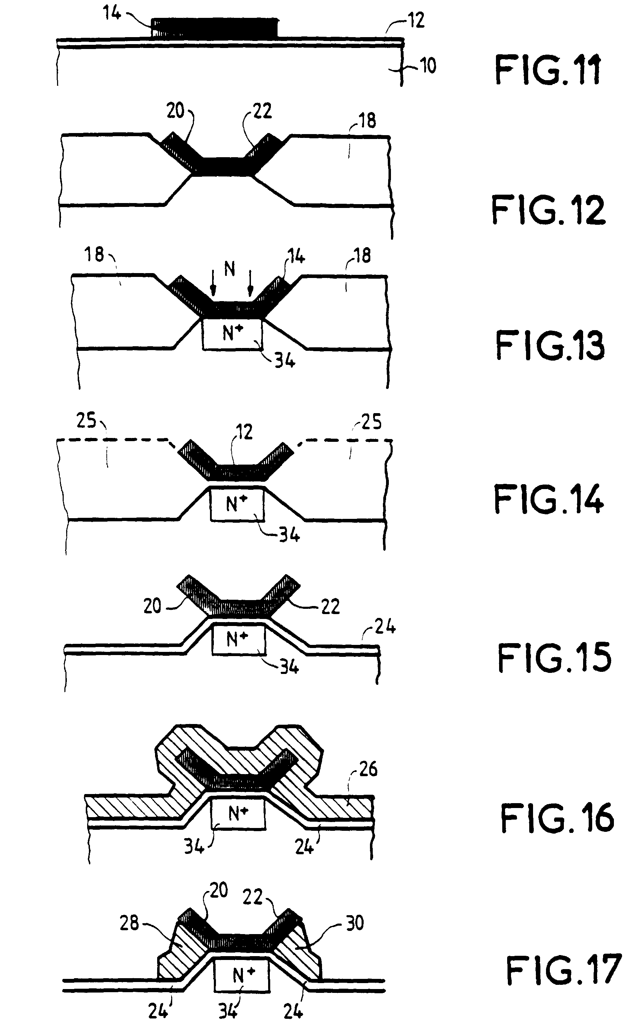

On enlève alors, par gravure chimique, une épaisseur uniforme de silicium polycristallin correspondant (au moins) à l'épaisseur de la couche 38 déposée. Le nitrure de silicium 14 est alors à nouveau dénudé. Il subsiste du silicium polycristallin constituant une électrode 40 dans tout l'espace situé entre les surplombs de nitrure, c'est-à-dire dans l'espace 25 évidé après l'oxydation épaisse. Cette électrode est disposée au dessus d'une bande 34 dopée constituant un drain, et elle est isolée de ce drain par la couche isolante mince 24. (figure 9).

Un point important dans le cas d'un drain antiéblouissement placé entre deux zones photosensibles ou deux zones de registre à transfert de charges, est le fait que les deux portions d'électrodes 28, 30 encadrant la bande dopée 34 soient très symétriques, et cela aussi bien dans la réalisation de la figure 7 (électrodes séparées) que dans la réalisation de la figure 9 (électrodes réunies). Le procédé selon l'invention permet d'obtenir cette symétrie.

On notera que dans des cas très particuliers où l'électrode 40 peut rester au même potentiel que le drain 34, on peut se dispenser de l'étape d'implantation ionique de la figure 7 et effectuer plutôt un dopage du substrat en utilisant la deuxième couche de silicium polycristallin 38. Dans ce cas, après l'étape de la figure 6, on enlève la couche isolante mince 24 entre les électrodes 28 et 30, celles-ci servant de masque; puis on dépose la deuxième couche de silicium (celui-ci étant dopé ou déposé en présence d'une impureté de dopage) de la manière indiquée ci-dessus. Le silicium dopé est alors en contact avec le substrat dans l'intervalle 32 et il sert de source de dopant pour former une région 34. On aboutirait à une structure similaire à celle de la figure 9, mais dans laquelle la couche 40 serait en contact direct avec la région 34.

Un point important du procédé selon l'invention est le fait que l'électrode 40 soit peu surélevée par rapport à la surface de silicium de part et d'autre du dispositif antiéblouissement : elle comble globalement (mais pas plus) l'espace qui a été formé par l'oxydation localisée épaisse du substrat (voir figure 2 et 3). Ceci est très important puisque le dispositif antiéblouissement va dans la pratique être recouvert par les électrodes des registres à transfert de charges qui doivent être protégés contre l'éblouissement. Il ne faut donc pas de passage de marche trop élevé ou trop abrupt pour ne pas risquer de rupture de ces électrodes. Le procédé des figures 1 à 9 convient donc particulièrement bien sur ces deux aspects : la marche n'est pas trop haute et elle n'est pas abrupte.

La figure 10 représente à titre d'exemple la configuration générale d'un dispositif à transfert de charges utilisant le dispositif d'antiéblouissement réalisé par le procédé selon l'invention. Les dispositifs antiéblouissement sont désignés par la référence AE; ce sont des bandes allongées très étroites constituées comme à la figure 7 ou à la figure 9.

Elles sont recouvertes d'électrodes allongées EL dans le sens perpendiculaires aux bandes AE. La succession d'électrodes EL définit un registre à transfert de charges constitué de colonnes de registres juxtaposés séparés par les bandes AE. Ces registres peuvent être photosensibles ou non. Les électrodes EL sont représentées par souci de simplicité avec des intervalles entre elles. En réalité il n'y a pas d'intervalle et elles sont mêmes le plus souvent partiellement recouvrantes. Chaque case de registre élémentaire est définie par l'espace situé sous une électrode EL entre deux bandes d'antiéblouissement AE.

Dans le cas d'un dispositif de prise de vue à transfert de trame, le procédé selon l'invention présente encore un avantage important : il permet de réaliser simultanément (donc de manière autoalignée) les bandes d'antiéblouissement d'une zone image et des bandes d'isolation entre registres d'une zone mémoire. La figure 10 représente la constitution d'un tel dispositif de prise d'image à transfert de trame. La partie supérieure du dispositif est une zone image ZI, constituée de cellules photosensibles C en colonnes adjacentes séparées par des dispositifs d'antiéblouissement AE. Les colonnes de cellules sont agencées chacune en registre à décalage. Au dessous de la zone image ZI, il y a une zone mémoire ZM constituée de registres à décalages correspondant chacun à un registre respectif en colonne de la zone image. La zone mémoire est masquée contre la lumière alors que la zone image ne l'est pas. Entre les registres verticaux de la zone mémoire on a prévu des colonnes d'isolation IS . En bas de la zone mémoire se situe un registre de lecture RL. En utilisant le procédé selon les figures 1 à 9, on voit que les zones d'isolation IS peuvent être faites au cours des étapes correspondant aux figures 1 et 2. Elles sont autoalignées avec les bandes AE, ce qui est important. La suite du procédé des figures 3 à 9 ne sera pas exécutée dans la zone mémoire, mais seulement dans la zone image si c'est uniquement dans la zone image que doivent se trouver des dispositifs d'antiéblouissement.

Dans une variante de procédé qui va maintenant être décrite en référence aux figures 11 à 17, on procède au dopage de la ligne 34 avant d'enlever l'oxyde épais 18, c'est-à-dire après l'étape de la figure 2.

Si on part à nouveau d'un substrat semiconducteur 10 qui peut être en silicium recouvert d'une couche isolante mince 12, on dépose une couche 14 de masquage contre l'oxydation similaire à celle qui a été décrite en référence à la figure 1. On grave cette couche pour laisser subsister une bande étroite (pouvant descendre jusqu'à 1,5 à 2 micromètres de large) de cette couche. (figure 11).

Par conséquent, au lieu de former une ouverture étroite comme à la figure 1, on laisse subsister une bande étroite.

On procéde à une oxydation thermique profonde du substrat de silicium. Une couche d'oxyde épais 18 se forme, sauf sous la couche de masquage 14. Les bords 20 et 22 de la couche de masquage se soulèvent durant cette étape d'oxydation, du fait du gonflement de la couche d'oxyde 18. (figure 12).

On implante alors l'impureté qui doit servir à former le drain 34 de part et d'autre duquel seront formées ultérieurement deux bandes conductrices. Par conséquent, au lieu de former d'abord les bandes conductrices puis la région dopée, on forme d'abord la région dopée.

L'implantation se fait à travers la couche de nitrure de silicium; celle-ci sert en effet de masque contre l'oxydation mais elle peut être assez mince pour laisser passer les impuretés implantées si l'implantation se fait avec une énergie suffisante. Dans cette étape d'implantation, ce sont les couches épaisses d'oxyde de silicium 18 qui serviront de masque empêchant la pénétration des impuretés en dehors de la zone située entre les bords relevés de la couche de masquage. Une zone dopée 34 est formée sous cette dernière zone. (figure 13).

On procède alors à l'enlèvement de l'oxyde 18 par désoxydation chimique, laissant un espace évidé 25 de part et d'autre de la couche de masquage 14 et de la région dopée 34. Les bords relevés 20 et 22 de la couche de masquage restent en surplomb au dessus des bords de l'espace évidé 25. (figure 14).

Si on désire que les grilles conductrices qu'on veut réaliser soient isolées du substrat 10, on forme alors, par oxydation thermique ou par dépôt, une couche isolante mince 24, en principe en oxyde de silicium. (figure 15).

On dépose alors une couche de silicium polycristallin 26 sur toute la surface du substrat, avec des conditions de dépôt telles que le dépôt suive les contours des irrégularités du substrat; en particulier, il faut que le silicium vienne se déposer sous les bords en surplomb 20 et 22 de la couche de masquage 14. (figure 16).

On attaque alors anisotropiquement, comme décrit en référence à la figure 6, le silicium de la couche 26 pour ne laisser subsister du silicium que sous les bords en surplomb 20 et 22. Le silicium subsistant constitue deux électrodes très étroites 28 et 30, encadrant une région dopée étroite 34 et autoalignées avec cette région dopée. Les dimensions totales en largeur de l'ensemble peuvent ne pas excéder 2 micromètres.

Tous les modes de réalisation décrits précédemment utilisent une étape d'oxydation épaisse suivie d'une étape de désoxydation pour former une ouverture recouverte partiellement par des bords en surplomb. C'est en effet le mode de réalisation le plus avantageux. Mais on pourrait aussi envisager un procédé dans lequel on forme non pas une couche de masquage contre l'oxydation mais une couche de masquage contre la gravure du silicium du substrat; on grave cette couche pour définir une bande non protégée; on grave le substrat dans cette bande, avec sous gravure au dessous des bords de la couche de masquage. Les bords restent en surplomb. On effectue la suite du procédé comme expliqué en référence aux figures 4 à 10 : éventuellement une formation d'isolant mince au fond de l'ouverture, puis un dépôt de silicum polycristallin suivant le contour de l'ouverture, y compris sous les bords en surplomb, puis une gravure du silicium en laissant subsister du silicium sous les surplombs. Dans ce cas, les surplombs sont horizontaux et non inclinés vers le haut comme sur les figures précédentes. Il est alors possible d'envisager que la gravure du silicum polycristallin soit une gravure chimique (isotropique) plutôt qu'une gravure par plasma (anisotropique verticale). En effet, même avec une gravure chimique il subsistera du silicium polycristallin sous les remblais dès lors que l'épaisseur de dépôt est suffisante par rapport à la hauteur de l'ouverture située sous les surplombs.

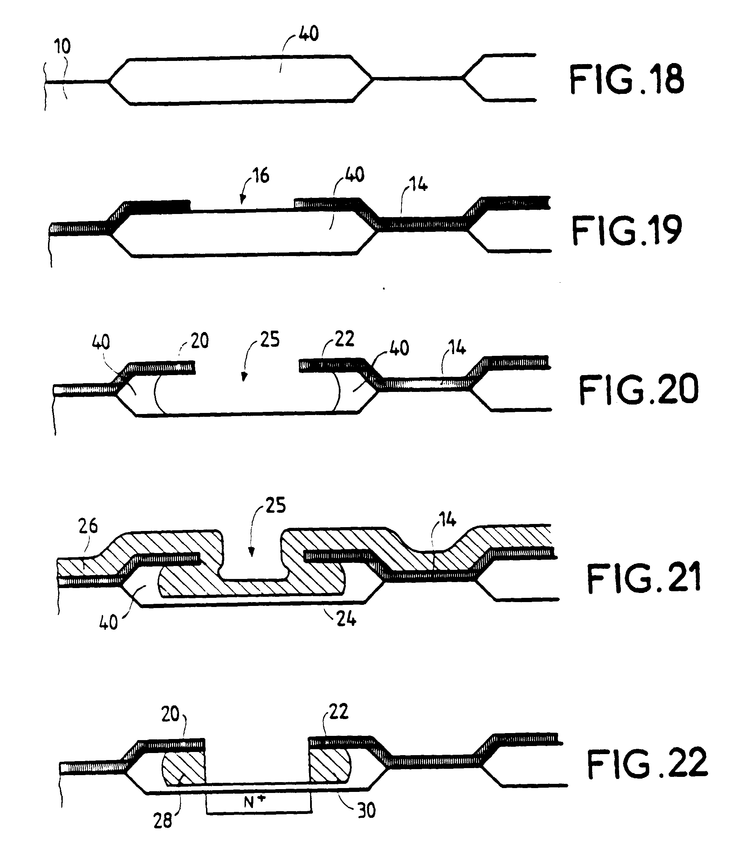

Enfin, dans le même esprit que le paragraphe qui précède, une variante de procédé également intéressante est représentée aux figures 18 à 22 :

On part d'un substrat 10 comportant au moins une couche semiconductrice superficielle; on forme sur ce substrat une couche isolante épaisse 40. Cette couche est formée de préférence par oxydation localisée du semiconducteur puisque cette étape est de toutes façons nécessaire pour d'autres éléments de circuit. Elle est alors en oxyde de silicium pour un substrat de silicium.

C'est le substrat ainsi recouvert qui va subir les étapes de l'invention : formation de surplombs puis dépôt et gravure de silicium polycristallin.

On dépose une couche de masquage 14, de préférence en nitrure de silicium, et on définit une ouverture 16 en forme de bande dans cette couche de masquage. La couche servira de protection dans une étape de gravure de la couche 40 (figure 19).

On attaque la couche 40 dans la bande 16, avec une gravure chimique. L'attaque est poursuivie jusqu'à mise à nu du substrat 10. Au cours de cette attaque, l'oxyde de silicum est éliminé au dessous des bords 20, 22 de la couche de masquage 14 et ceux-ci restent en surplomb au dessus d'une ouverture 25. Le substrat est denudé dans cette ouverture (figure 20).

Si les électrodes qu'on désire former doivent être isolées du substrat par une mince couche isolante 24, on forme alors cette dernière, par exemple par oxydation thermique.

Une couche de silicium polycristallin 26 est ensuite déposée, dans des conditions de basse température et basse pression telles que son pouvoir couvrant soit élevé et qu'elle recouvre les bords intérieurs de l'ouverture 25, y compris sous les bords en surplomb 20 et 22 (figure 21).

L'épaisseur de silicium déposée est de préférence à peu près égale à la moitié de l'épaisseur de la couche 40; cette dernière est par exemple d'environ 1 micromètre, de sorte que 5000 Angströms de silicium conviennent. La longueur des surplombs est environ égale à l'épaisseur de la couche 40.

On grave alors, de préférence par attaque anisotropique verticale (gravure sous plasma), la couche de silicium déposée, pour ne laisser subsister essentiellement que des bandes conductrices 28 et 30 situées sous les surplombs 20 et 22 (figure 22). Une gravure chimique peut aussi être envisagée si elle laisse subsister sous les surplombs une quantité suffisante de silicium. Le résultat de la gravure par plasma ou de la gravure chimique est indiqué à la figure 22.

On peut effectuer à ce stade une implantation ionique d'impuretés de dopage du substrat, comme indiqué en référence à la figure 7. Toutefois, les variantes indiquées en référence aux figures 8 et 9 sont également applicables ici. On pourrait d'ailleurs envisager aussi que l'implantation soit faite après l'étape de la figure 20 (ou respectivement figure 4).

Un des avantages de ce mode de réalisation des figures 18 à 22 est la présence d'une isolation latérale épaisse de chaque côté des bandes conductrices 28 et 30 lorsqu'on a besoin d'une telle isolation.

## Revendications

1. Procédé de fabrication d'un système d'antiéblouissement pour dispositif à transfert de charges, ce système comportant deux électrodes étroites isolées par rapport à un substrat semiconducteur et s'étendant symétriquement de part et d'autre d'une région dopée formée dans ce substrat et formant un drain d'évacuation de charges, comportant les étapes suivantes :
- a) on dépose sur un substrat (10, 12 ; 10, 40) une couche (14) de masquage ;
- b) on grave cette couche selon un motif définissant au moins une bande non protégée (16) ;
- c) on forme une ouverture dans le substrat là où il n'est pas protégé par la couche de masquage, cette ouverture (25) s'étendant également sous les bords de la couche de masquage, laissant ces bords (20, 22) en surplomb au-dessus de l'ouverture ;
- d) on dépose du silicium polycristallin (26) épousant le contour du substrat et des bords en surplomb ;
- e) on enlève le silicium par gravure sans masque de sorte que des bandes de silicium très étroites (28, 30) subsistent essentiellement uniquement sous les bords en surplomb et forment lesdites deux électrodes étroites;
- f) on forme, postérieurement à l'étape b), une région dopée (34) dans le substrat, formant ladite région de drain d'évacuation de charges, cette région étant autoalignée par rapport aux deux électrodes étroites.

2. Procédé selon la revendication 1, caractérisé en ce que le substrat semiconducteur (10) est recouvert d'une couche isolante épaisse (40), en ce que la couche de masquage est une couche de masquage contre la gravure de la couche isolante, et en ce que l'étape c d'ouverture du substrat comporte une étape de gravure de la couche isolante épaisse avec sous gravure sous les bords de la couche de masquage.

3. Procédé selon la revendication 1, caractérisé en ce que la couche de masquage est une couche de masquage contre l'oxydation, et en ce que la formation de l'ouverture comporte une étape d'oxydation thermique épaisse du substrat là où il n'est pas protégé et une étape d'enlèvement de l'oxyde épais.

4. Procédé selon l'une des revendications 1 à 3, caractérisé en ce qu'une couche mince isolante (24) est formée sur le substrat avant dépôt de la couche de silicium.

5. Procédé selon l'une des revendications 1 à 4, caractérisé en ce que la formation de la région dopée comprend l'implantation d'une impureté dans le substrat semiconducteur après gravure du silicium, le substrat étant masqué par les bandes de silicium étroites (28, 30).

6. Procédé selon l'une des revendications 1 à 5, caractérisé en ce que après gravure du silicium on dépose une deuxième couche de silicium polycristallin (38) dans des conditions propres à combler l'intervalle entre les bandes étroites de silicium et à former une surépaisseur de silicium au-dessus de cet intervalle, et en ce qu'on enlève ensuite uniformément une épaisseur de silicium polycristallin au moins égale à l'épaisseur déposée en dernier, en laissant subsister du silicium (40) entre les bandes étroites (28, 30).

7. Procédé selon la revendication 3, caractérisé en ce que la formation de la région dopée comprend l'implantation d'une impureté dans le substrat à travers la couche de masquage (14) après formation de l'oxyde épais et avant enlèvement de celui-ci, l'oxyde épais servant de masque contre l'implantation d'impuretés.

8. Procédé selon la revendication 1, pour réaliser une matrice de prise de vue à transfert de trame comportant une zone d'image photosensible (ZI) et une zone de mémoire de trame (ZM), la zone d'image comportant des colonnes de points photosensibles (C) alignées chacune avec une colonne respective de zones de stockage de la zone de mémoire, caractérisé en ce qu'il comporte une étape de formation d'oxyde de silicium épais selon un motif définissant simultanément d'une part l'emplacement de dispositifs d'antiéblouissement (AE) séparant les colonnes adjacentes de pixels de la zone image et d'autre part des colonnes d'oxyde épais (IS) séparant les colonnes adjacentes correspondantes de zones de stockage de la zone de mémoire, et en ce que l'ensemble d'étapes c à f est effectué dans les emplacements de dispositifs d'antiéblouissement de la zone d'image mais pas dans les colonnes d'oxyde épais de la zone mémoire.

9. Procédé selon la revendication 8, caractérisé en ce que les étapes a et b servent à la définition des zones d'oxyde épais et sont effectuées à la fois dans les emplacements de dispositifs d'antiéblouissement de la zone image et dans les colonnes d'oxyde épais de la mémoire.

10. Procédé selon la revendication 8, caractérisé en ce que les étapes a et b sont effectuées après formation des zones d'oxyde épais, en ce que la couche de masquage est une couche de masquage contre la gravure de l'oxyde épais, et en ce que l'étape c d'ouverture du substrat comporte une étape de gravure de l'oxyde épais avec sous-gravure sous les bords de la couche de masquage.

11. Procédé selon l'une des revendications 8 à 10, caractérisé en ce qu'une couche mince isolante (24) est formée sur le substrat avant dépôt de la couche de silicium.

12. Procédé selon l'une des revendications 8 à 11, caractérisé en ce que la formation de la région dopée comprend l'implantation d'une impureté dans le substrat semiconducteur après gravure du silicium, le substrat étant masqué par les bandes de silicium étroites (28, 30).

13. Procédé selon l'une des revendications 8 à 12, caractérisé en ce que après gravure du silicium on dépose une deuxième couche de silicium polycristallin (38) dans des conditions propres à combler l'intervalle entre les bandes étroites de silicium et à former une surépaisseur de silicium au-dessus de cet intervalle, et en ce qu'on enlève ensuite uniformément une épaisseur de silicium polycristallin au moins égale à l'épaisseur déposée en dernier, en laissant subsister du silicium (40) entre les bandes étroites (28, 30).

## Claims

1. Process for fabricating an antidazzle system for a charge-coupled device, this system having two narrow electrodes that are insulated from a semiconductor substrate and extend symmetrically on each side of a doped region formed in this substrate and that form a charge-removal drain, which includes the following steps:
- a) a masking layer (14) is deposited on a substrate (10, 12; 10, 40);
- b) this layer is etched into a pattern defining at least one unprotected strip (16);
- c) an aperture is formed in the substrate at the place where it is not protected by the masking layer, this aperture (25) also extending beneath the edges of the masking layer, leaving these edges (20, 22) overhanging the aperture;
- d) polycrystalline silicon (26) is deposited, the polycrystalline silicon matching the contour of the substrate and of the overhanging edges;
- e) the silicon is removed by etching, without masking, so that very narrow silicon strips (28, 30) remain essentially only beneath the overhanging edges and form the said two narrow electrodes; and
- f) after step b) a doped region (34) is formed in the substrate, which forms the said charge-removal drain region, this region being self-aligned with respect to the two narrow electrodes.

2. Process according to Claim 1, characterized in that the semiconductor substrate (10) is covered with a thick insulating layer (40), in that the masking layer is a masking layer to prevent the insulating layer from being etched, and in that step c, for making an aperture in the substrate, includes a step of etching the thick insulating layer with underetching beneath the edges of the masking layer.

3. Process according to Claim 1, characterized in that the masking layer is an oxidation-preventing masking layer and in that the formation of the aperture includes a step of thick thermal oxidation of the substrate at the point where it is not protected and a step of removing the thick oxide.

4. Process according to one of Claims 1 to 3, characterized in that a thin insulating layer (24) is formed on the substrate before the silicon layer is deposited.

5. Process according to one of Claims 1 to 4, characterized in that the formation of the doped region comprises implanting an impurity into the semiconductor substrate after the silicon has been etched, the substrate being masked by the narrow silicon strips (28, 30).

6. Process according to one of Claims 1 to 5, characterized in that, after the silicon has been etched, a second layer of polycrystalline silicon (38) is deposited under conditions suitable for filling the gap between the narrow silicon strips and for forming a silicon overthickness above this gap, and in that a polycrystalline silicon thickness at least equal to the most recently deposited thickness is then uniformly removed, allowing some silicon (40) to remain between the narrow strips (28, 30).

7. Process according to Claim 3, characterized in that the formation of the doped region comprises implanting an impurity into the substrate through the masking layer (14) after the thick oxide has been formed and before the latter has been removed, the thick oxide serving as a mask preventing the implantation of impurities.

8. Process according to Claim 1, in order to produce a frame-transfer image pick-up matrix having a photosensitive image zone (ZI) and a frame memory zone (ZM), the image zone having columns of photosensitive spots (C), each column being aligned with a respective column of the storage zones in the memory zone, characterized in that it includes a step of forming thick silicon oxide in a pattern which simultaneously defines, on the one hand, the location of the antidazzle devices (AE) separating the adjacent columns of pixels of the image zone and, on the other hand, the location of the thick-oxide columns (IS) separating the corresponding adjacent columns of storage zones of the memory zone, and in that all steps c to f are carried out in the locations of antidazzle devices of the image zone but not in the thick-oxide columns of the memory zone.

9. Process according to Claim 8, characterized in that steps a and b serve to define the thick-oxide zones and are carried out both in the locations of antidazzle devices of the image zone and in the thick-oxide columns of the memory.

10. Process according to Claim 8, characterized in that steps a and b are carried out after the thick-oxide zones have been formed, in that the masking layer is a masking layer to prevent the thick oxide from being etched and in that step c, for making an aperture in the substrate, includes a step of etching the thick oxide with underetching beneath the edges of the masking layer.

11. Process according to one of Claims 8 to 10, characterized in that a thin insulating layer (24) is formed on the substrate before the silicon layer is deposited.

12. Process according to one of Claims 8 to 11, characterized in that the formation of the doped region comprises implanting an impurity into the semiconductor substrate after the silicon has been etched, the substrate being masked by the narrow silicon strips (28, 30).

13. Process according to one of Claims 8 to 12, characterized in that, after the silicon has been etched, a second layer of polycrystalline silicon (38) is deposited under conditions suitable for filling the gap between the narrow silicon strips and for forming a silicon overthickness above this gap, and in that a polycrystalline thickness silicon at least equal to the most recently deposited thickness is then uniformly removed, allowing some silicon (40) to remain between the narrow strips (28, 30).

## Patentansprüche

1. Verfahren zur Herstellung eines Blendschutzsystems für eine Ladungstransfer-Vorrichtung, das zwei schmale und gegenüber einem halbleitenden Substrat isolierte Elektroden enthält, die sich symmetrisch zu beiden Seiten einer einen Ladungstransferdrain bildenden und in diesem Substrat ausgebildeten dotierten Zone erstrecken, wobei das Verfahren folgende Schritte aufweist:
- a) auf die Oberfläche eines Substrats (10, 12; 10, 40) wird eine Maskenschicht (14) aufgebracht;
- b) diese Schicht wird gemäß einem Motiv graviert, das mindestens ein nicht geschütztes Band (16) definiert;
- c) eine Öffnung (25) wird in dem Substrat dort erzeugt, wo es nicht durch eine Maskenschicht geschützt ist, wobei diese Öffnung sich auch unter die Ränder der Maskenschicht erstreckt und die Ränder (20, 22) oberhalb dieser Öffnung überstehen läßt;
- d) polykristallines Silizium (26) wird aufgebracht, das die Umrisse des Substrats und der überstehenden Ränder einhüllt;
- e) das Silizium wird durch Abätzen ohne Maske entfernt, sodaß sehr schmale Siliziumbänder (28, 30) im wesentlichen nur unter den überstehenden Rändern verbleiben, die die beiden schmalen Elektroden bilden;
- f) nach dem Verfahrensschritt b) wird eine dotierte zone (34) in dem Substrat gebildet, die den Drainbereich zur Ladungsabfuhr bildet und bezüglich der beiden schmalen Elektroden ohne weiteres zentriert ist.

2. Verfahren nach Anspruch 1, dadurch gekennzeichnet, daß das Halbleitersubstrat (10) mit einer dicken Isolierschicht (40) bedeckt wird, daß die Maskenschicht eine Maskierung gegen eine Ätzung der Isolierschicht bewirkt und daß der Verfahrensschritt c) der Öffnung des Substrats einen Verfahrensschritt enthält, bei dem die dicke isolierende Schicht graviert wird und eine Untergravur unter den Rändern der Maskenschicht erfolgt.

3. Verfahren nach Anspruch 1, dadurch gekennzeichnet, daß die Maskenschicht gegen Oxidation schützt und daß die Bildung der Öffnung einen Schritt der tiefwirkenden thermischen Oxidation des Substrats an der Stelle, an der es nicht geschützt ist, sowie einen Schritt der Entfernung der dicken Oxidschicht enthält.

4. Verfahren nach einem der Ansprüche 1 bis 3, dadurch gekennzeichnet, daß eine dünne Isolierschicht (24) auf das Substrat vor dem Aufbringen der Siliziumschicht aufgebracht wird.

5. Verfahren nach einem der Ansprüche 1 bis 4, dadurch gekennzeichnet, daß die Bildung der dotierten Zone die Implantierung eines Dotierstoffs in das Halbleitersubstrat nach dem Abätzen des Siliziums enthält, wobei das Substrat durch die schmalen Siliziumbänder (28, 30) maskiert ist.

6. Verfahren nach einem der Ansprüche 1 bis 5, dadurch gekennzeichnet, daß nach dem Abätzen des Siliziums eine zweite Schicht (38) aus polykristallinem Silizium unter solchen Bedingungen aufgebracht wird, daß der Zwischenraum zwischen den schmalen Bändern aus Silizium gefüllt wird und eine Überdicke an Silizium oberhalb des Zwischenraums entsteht, und daß dann gleichmäßig eine Schicht polykristallinen Siliziums einer Dicke von mindestens gleich der zuletzt aufgebrachten Dicke abgetragen wird, wobei Silizium (40) zwischen den schmalen Bändern (28, 30) verbleibt.

7. Verfahren nach Anspruch 3, dadurch gekennzeichnet, daß die Bildung der dotierten Zone die Implantierung eines Dotierstoffs in das Substrat durch die Maskenschicht (14) hindurch nach der Bildung der dicken Oxidschicht und vor der Entfernung dieser Schicht enthält, wobei die dicke Oxidschicht als Maske gegen die Implantierung von Dotierstoffen dient.

8. Verfahren nach Anspruch 1 zur Herstellung einer Bildaufzeichnungsmatrix mit Rahmentransfer, wobei die Matrix eine lichtempfindliche Zone (ZI) und eine Rahmenspeicherzone (ZM) enthält und die Bildzone Spalten von lichtempfindlichen Punkten (C) enthält, die je mit einer entsprechenden Spalte von Speicherzellen der Speicherzone fluchten, dadurch gekennzeichnet, daß das Verfahren einen Schritt der Bildung von dickem Siliziumoxid gemäß einem Motiv aufweist, das sowohl einerseits die Lage von Blendschutzvorrichtungen (AE) zwischen den benachbarten Spalten von Bildpunkten der Bildzone als auch andrerseits die Lage der Spalten einer dicken Oxidschicht (IS) zwischen den entsprechenden benachbarten Spalten von Speicherzellen der Speicherzone definiert, und daß die Verfahrensschritte d) bis f) an den Stellen von Blendschutzvorrichtungen der Bildzone, nicht aber in den Spalten einer dicken Oxidschicht des Speicherbereichs durchgeführt werden.

9. Verfahren nach Anspruch 8, dadurch gekennzeichnet, daß die Schritte a) und b) zur Definition der Zonen mit dicker Oxidschicht dienen und sowohl an den Stellen von Blendschutzvorrichtungen der Bildzone als auch in den Spalten mit einer dicken Oxidschicht der Speicherzone wirksam werden.

10. Verfahren nach Anspruch 8, dadurch gekennzeichnet, daß die Verfahrensschritte a) und b) nach der Bildung der Zonen mit einer dicken Oxidschicht durchgeführt werden, daß die Maskenschicht gegen das Abätzen der dicken Oxidschicht schützt und daß der Schritt c) mit der Öffnung des Substrats einen Schritt enthält, bei dem die dicke Oxidschicht abgeätzt wird und auch eine Untergravur unter den Rändern der Maskenschicht erfolgt.

11. Verfahren nach einem der Ansprüche 8 bis 10, dadurch gekennzeichnet, daß eine dünne isolierende Schicht (24) auf dem Substrat vor dem Aufbringen der Siliziumschicht gebildet wird.

12. Verfahren nach einem der Ansprüche 8 bis 11, dadurch gekennzeichnet, daß die Bildung der dotierten Zone die Implantierung eines Dotierstoffs in das Halbleitersubstrat nach dem Abätzen des Siliziums enthält, wobei das Substrat durch die schmalen Siliziumbänder (28, 30) maskiert ist.

13. Verfahren nach einem der Ansprüche 8 bis 12, dadurch gekennzeichnet, daß nach dem Abätzen des Siliziums eine zweite Schicht aus polykristallinem Silizium (38) unter solchen Bedingungen aufgebracht wird, daß der Zwischenraum zwischen den schmalen Bändern aus Silizium gefüllt wird und eine Überdicke an Silizium oberhalb dieses Zwischenraums entsteht, und daß dann gleichmäßig eine Schicht polykristallinen Siliziums einer Dicke mindestens gleich dieser zuletzt genannten Schicht entfernt wird, sodaß Silizium (40) nur zwischen den schmalen Bändern (28, 30) verbleibt.
